# EUROPEAN PATENT APPLICATION

(11) **EP 2 119 813 A1**
(43) Date of publication of application: **18.11.2009**
(21) Application number: 08156389.2
(22) Date of filing: 16.05.2008
(51) Int. Cl.: C23C 26/00, B05D 1/26, B65H 18/02, B65H 18/10, C23C 14/04, C23C 14/20, C23C 14/56

(54) **Coating device with insulation**

(71) Applicant: Applied Materials, Inc., Santa Clara, CA 95054 (US)
(72) Inventor: Achtner, Wolfgang, 63477 Maintal (DE); Klemm, Günter, 63667 Nidda (DE); Olbrich, Peter, 60388 Frankfurt (DE)
(74) Representative: Zimmermann & Partner

(57) **Abstract**

A coating device for coating a flexible substrate and methods of manufacturing and operating a coating device are described. The coating device includes a roll having an axis and two or more insulating layers, wherein a first insulating layer is applied on a first area and a second insulating layer is applied on a second area on the surface of the roll, the first and second area being circumferential, and wherein at least one insulating layer is adapted to be applied as a vapor or as a fluid, and a central area between the first and second area, and a flexible substrate receiving area having two or more boundaries, wherein a first boundary lies within the first area and a second boundary lies within the second area.

## Description

### FIELD OF THE INVENTION

The present invention relates to guiding of flexible substrates, e.g., for coating thereof. Particularly, it relates to a coating device having an improved roll for better substrate handling. Further, it relates to a method of manufacturing such a coating device and a method of operating such a coating device. Specifically, it relates to a coating device and methods of manufacturing and operating a coating device.

### BACKGROUND OF THE INVENTION

Coated films or foils are in high demand in packaging and semiconductor production, and other industries. Thereby, flexible substrates like films, e.g., made out of a polymer, are coated with a desired material. A coating is applied, e.g., in form of a metallic vapor that is deposited onto the film. Such films may serve in packaging industry, electronic industry, semiconductor industry or the like.

Coating devices performing this task usually have a processing roll, e.g. of cylindrical shape, over which the film is transported while being coated. For the coating process it is often desirable to increase the adhesion of the film to the processing roll. An increased adhesion can improve cooling of the flexible substrate, which might be desired for the deposition process. Increased adhesion can be realized by biasing either or both of the processing roll and the flexible substrate such that a difference in the electrostatic potentials of roll and film exists whereby the film is attracted to the roll by electrostatic forces.

However, this increased adhesion between film and roll may cause problems in detaching the film from the roll during transportation.

Consequently, the guiding of a flexible substrate needs to be further improved, in particular for high speed roll-to-roll applications.

### SUMMARY

In light of the above, a coating device for coating a flexible substrate according to independent claims 1 and 4, and a method of manufacturing such a coating device according to independent claims 10 and 11 are provided.

According to one embodiment, a coating device for coating a flexible substrate is provided. The coating device includes a roll having an axis and two or more insulating layers, wherein a first insulating layer is applied on a first area and a second insulating layer is applied on a second area on the surface of the roll, the first and second area being circumferential, and wherein at least one insulating layer is adapted to be applied as a vapor or as a fluid, and a central area between the first and second area, and a flexible substrate receiving area having two or more boundaries, wherein a first boundary lies within the first area and a second boundary lies within the second area.

According to another embodiment, a coating device for coating a flexible substrate is provided. The coating device includes a roll having an axis and two or more insulating layers adapted to be seamlessly applied on the roll. Therein, a first insulating layer is applied on a first area and a second insulating layer is applied on a second area on the surface of the roll, the first and second area being substantially circumferential. Further, the coating device includes a central area between the first and second area and a substrate receiving area having two or more boundaries, wherein a first boundary lies within the first area and a second boundary lies within the second area.

According to yet other embodiments, methods of manufacturing a coating device are provided. Thereby, according to one embodiment, a method of manufacturing a coating device includes applying two or more insulating layers as vapor or fluid on a roll having an axis, wherein a first insulating layer is applied on a first area and a second insulating layer is applied on a second area on the surface of the roll, the first and second area being substantially circumferential, and wherein there is a central area between the first and second area.

According to still another embodiment, a method of manufacturing a coating device includes applying two or more insulating layers adapted to be seamlessly applied on a roll having an axis, wherein a first insulating layer is applied on a first area and a second insulating layer is applied on a second area on the surface of the roll, the first and second area being substantially circumferential, and wherein there is a central area between the first and second area.

Embodiments are also directed to methods for manufacturing and operating the disclosed coating device. These method steps may be performed manually or automated, e.g. controlled by a computer programmed by appropriate software, by any combination of the two or in any other manner.

Further advantages, features, aspects and details that can be combined with embodiments described herein are evident from the dependent claims, the description and the drawings.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
Fig. 1 shows a schematic view of a roll-to-roll coating device as an example for which embodiments of the invention can be utilized;
Fig. 2 shows a schematic view of a process roll for a coating device according to embodiments described herein;
Fig. 3 shows a schematic view of a mask for use with a coating device according to embodiments described herein;
Fig. 4A shows a schematic view of a method of operating a coating device according to embodiments described herein;
Fig. 4B shows a schematic view of a method of operating a coating device according to embodiments described herein;
Fig. 5 shows a schematic view of a method of operating a coating device according to embodiments described herein.
Fig. 6 shows a flow-chart illustrating a method of operating a coating device according to embodiments described herein.

### DETAILED DESCRIPTION OF THE INVENTION

Reference will now be made in detail to the various embodiments of the invention, one or more examples of which are illustrated in the figures. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Within the following description of the drawings, the same reference numbers refer to the same components. Generally, only the differences with respect to the individual embodiments are described.

A "flexible substrate", as referred to herein, includes, but is not limited to, films or foils of diverse materials such as polyester (PET), polypropylene (PP), PEN, PPS and PVC. Thereby, typically, a foil or other flexible substrate can be considered thin or ultra thin if it has a thickness below 50 µm, typically if it has a thickness of below 5 µm or even 2 µm such as, e.g., a submicron thickness. Typically, Ultra Thin Films (UTF) may have a thickness of 2 µm or below, e.g., 0.7 µm.

A "roll", as referred to herein, includes, but is not limited to, processing rolls, guiding rolls or other rolls, which might be, for example, of cylindrical shape. Embodiments of the invention may be applied to any workpiece, component or unit which has an axis and over which material is transported whereby electrostatic attraction forces are provided.

The term "polymer", as referred to herein, includes combinations or mixtures or compounds of polymers. Therefore, the term includes substances such as copolymers or terpolymers.

For ease of reference, the term "solvably combinable" as used herein is generally understood as referring to at least two objects at least one of which can be combined with at least one other object in a way that this combination is adapted to be detachable or can be undone afterwards without undue effort. Here, the term "undue effort" is understood as including, but not being limited to, scrubbing off of one object from another, desolving one object applied to another, peeling off of one object from another, such that a breaking of an integral design is provided. For example, forcing apart two pieces welded together or glued together by a glue that cannot easily be dissolved by a solvent, or dismantling integrally connected layers by use of abrasive objects is considered an undue effort.

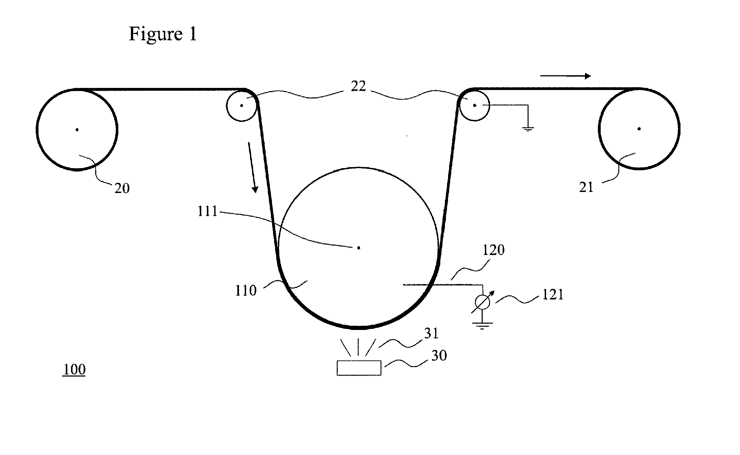

Fig. 1 shows a coating device 100. As shown in Fig. 1, a flexible substrate 10 such as a web or a film is provided on a roll 20. The flexible substrate 10 is unwound from the first roll 20, is processed in the device 100 and is wound on a second roll 21. Accordingly, the unprocessed flexible substrate is fed from the first roll 20 and the processed substrate is fed to the second roll 21. As shown in Fig. 1, the flexible substrate 10 can be processed on a processing roll 110 having an axis 111. According to yet other embodiments, which can be combined with any of the embodiments described herein, one or more additional rolls 22 may be provided on one or each side of the processing roll 110. These additional rolls may be used for guiding the flexible substrate, controlling the tension of the flexible substrate, providing or removing charge from the flexible substrate, and combinations thereof.

Generally, according to yet further embodiments, also two or more processing rolls might be provided between the first roll and the second roll. It will be appreciated by a skilled person that the embodiments and the details thereof, which are generally described with respect to one processing roll between the first roll 20 and the second roll 21 may also be correspondingly applied if two or more processing rolls or two or more other rolls are provided between the first roll 20 and the second roll 21.

Generally, as shown on Fig. 1, a coating device material source 30 can be provided for coating the flexible substrate 10 with a film of the coating material 31. According to different embodiments, which can be combined with any of the documents described herein, the coating can be a thermal evaporation, an electron beam evaporation, a sputtering process, CVD processes, plasma enhanced processes or combinations thereof. Generally, these processes might provide a temperature load on the flexible substrate and/or might require a temperature control of the substrate for optimizing the coating process.

Accordingly, a temperature control, typically a cooling, is provided in the processing roll 110 in order to control the temperature of the flexible substrate 10. The effectiveness of the cooling or temperature control can thereby dependent on the contact between the flexible substrate 10 and the roll 110. Thus, a contact improvement can be provided, which can typically be an electrostatic force between the flexible substrate and the roll.

As shown in Fig. 1, according to embodiments described herein, a potential difference between the flexible substrate 10 and the processing roll 110 can be provided. The flexible substrate 10 can be charged by providing electrons on the flexible substrate. Thereby, a negative charge can be applied to the flexible substrate with an electron source, such as an electron flood gun, a linear electron gun, an electron beam, or the like. If the processing roll is grounded as indicated by connection 120 of roll 110 to ground and as corresponding to a switched-off voltage source 121 or a non-existing voltage source 121, the charge on the flexible substrate provides the potential difference to the grounded roll 110.

According to yet other embodiments, additionally or alternatively, the processing roll 110 can be charged by providing a voltage by the voltage source 121 to the roll 110 via connection 120. Thus, the potential difference can be given by the voltage of the voltage source in the case of an uncharged flexible substrate. In the case of a charged flexible substrate, the potential difference is given by Uᵣₒₗₗ-U_{substrate}. Accordingly, if U_{substrate} is negative, the potential difference is given by Uᵣₒₗₗ+|U_{substrate}|.

According to embodiments described above and referring to charging of the web and/or the roll the potential difference might be removed before the flexible substrate is removed from the processing roll for some embodiments. This can be realized, e.g., by contacting the web with a ground roll (not shown) or applying a charge of different polarity (such as ions in case of a negatively charged flexible substrate) on the flexible substrate or irradiating the flexible substrate, e.g., by x-rays. Other embodiments might not be provided with a discharging unit.

However, it is generally difficult to remove the charge entirely, in particular if high flexible substrate speeds are provided. Thus, there might be some remaining charge, which might be removed at a later stage. As one exemplary embodiment, which can be combined with other embodiments described herein, a grounded guiding roller 22 can be provided (see Fig. 1), e.g., to remove remaining charge from a web, film or the like.

Excess charges remaining on the flexible substrate and resulting forces may cause its edges to flip around, wrinkle or even tear, especially if the film is thin. The flipping, wrinkling or tearing of the edges of a substrate may also result from a different charging behavior of a region near the edge. Stripes near the edge may, e.g., remain uncoated while the interior region is coated, e.g. metalized.

According to different embodiments described herein, means for preventing or reducing damage to the edges of the flexible substrate are provided. Thereby, a local insulation is provided by insulating at least those areas of the processing roll on which the edges of the flexible substrate are to be in contact with the processing roll.

Generally, insulation could be provided by insulating stripes of ordinary adhesive tape that is wound around the processing roll on the surface area where the edges of a film are during processing. However, such stripes of tape might require further improvement in light of at least one of the following aspects. First, it is difficult to cut and apply the tape to the roll in a way that the seam between the ends of the tape is small; second, such a seam and even the thickness of the tape itself may cause problems, especially the thinner the film is, as the profiles of seam or tape may lead to wrinkles in the film; third, glue leaking from under the tape may wrinkle or even destroy the film in the process of detaching the film from the roll; fourth, such stripes of tape are difficult to remove from the roll, e.g. in case the roll has to be cleaned. Fifth, the thickness of a tape may block the passage of heat, e.g. from the film to the roll in case the film is meant to be cooled.

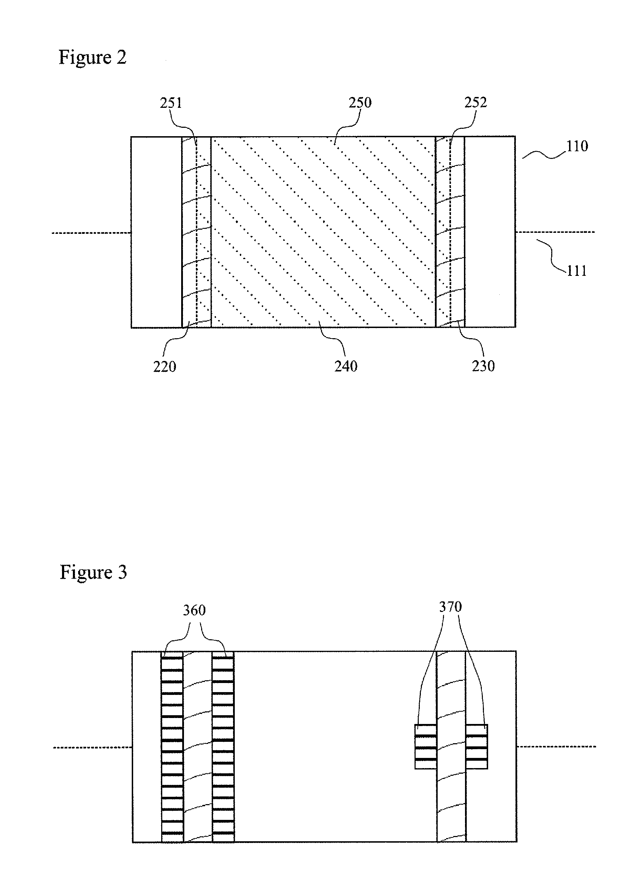

As shown in Fig. 2, according to some embodiments, the coating device 100 includes a roll 110 that is adapted to be biased with a voltage. As shown in Fig. 2, the roll 110 has an axis 111, which is shown as a dashed line. The roll 110 can be rotated around the axis 111. Two insulating layers 220 and 230 are shown. The layers are applied on a first and second area on the surface of the roll formed as two circumferential stripes between which there is a central area 240. Further, a flexible substrate receiving area 250, i.e., a receiving area for a flexible substrate, is shown schematically. Therein, the roll-touching part of a flexible substrate lies during guiding the substrate over the roll 110, e.g., for processing.

The first insulating layer 220 is applied on a first area 221 of the surface of the roll, the second insulating layer 230 is applied on a second area 231 of the surface of the roll, and the two boundaries 251 and 252 of the flexible substrate receiving area lie within the first and second area respectively. Thereby, the boundaries 251 and 252 substantially correspond to the edges of the flexible substrate during operation.

According to different embodiments, which can be combined with any of the embodiments described herein, at least one of the insulating layers, preferably both, can be applied in form of a vapor or a fluid, where a fluid may be a gas or a liquid. A vapor or fluid might be deposited to form an insulating layer. The vapor or fluid might cure after application.

In typical embodiments the width of the first or second area and, therefore, the width of the first or second insulating layer can be from 2 mm to 25 mm, typically from 5 and 15 mm. This statement shall also apply in the situation in which the width of an insulating layer is not substantially constant but varies along a circumferential path. In such a situation the statement is construed to mean that the width of the insulating layer is nowhere below 2 mm and nowhere above 25 mm as measured on the surface of the roll in a direction parallel to the axis.

According to yet further embodiments, which can be combined with any of the embodiments described herein, the width of the region in which the insulating layers and the flexible substrate receiving area overlaps is at least 2.5 mm, typically, between 2.5 mm and 10 mm.

According to different embodiments, a mask or templet may be used to facilitate the application of insulating layers, applied in the form of vapor or fluid, where the mask defines at least the dimension of an insulating layer parallel to the axis or defines the area of an insulating layer completely. Fig. 3 shows two examples of such masks according to embodiments described herein. Mask 360 defines the area of an insulating layer completely whereas mask 370 only defines one dimension, namely the axial dimension, which means the dimension parallel to the axis. A mask 360 or 370 might be held close to the surface by some holding device or by hand and the roll might be rotated while the insulating layer is applied.

According to other embodiments, at least one of the insulating layers may extend to a boundary of the roll. According to yet further embodiments, optional further insulating layers can be provided. This might apply, e.g., in a case when two flexible substrates are processed on one roll, or for any other reason. Thereby, further insulating layers can be arranged outside of further central areas between the respective insulating layers. Alternatively or additionally, further substrate receiving areas can be provided. Generally, according to embodiments described herein, a central area can be located substantially in the middle of a roll or substantially in the middle of a substrate receiving area. However, according to other embodiments, the central area can be displaced with respect to the middle of the surface of the roll as seen in the direction of the axis.

For embodiments, for which more than one area on the roll is provided on which insulating material is applied, several masks each with one opening, or one or more masks each having several openings for defining these areas can be provided. Thereby, as a further optional modification several holding devices for holding the masks close to the roll while applying the insulating layer can be provided. The features described in the above paragraph may be combined with the features of other embodiments described herein as single features or as groups of features.

According to some embodiments, a coating device for coating a flexible substrate is provided. The coating device includes a roll having an axis, the roll being adapted to be biased with a voltage. Two or more insulating layers adapted to be seamlessly applied on the roll are provided. According to further embodiments, which can alternatively or additionally be implemented, the at least two insulating layers can be solvably combinable with areas on the roll. Different areas can be provided, e.g., a central area and at least a first and a second area for applying insulating layers.

An insulating layer that is applied as vapor or fluid may be a layer adapted to be applied seamlessly. Such an insulating layer may also be solvably combinable with the roll, however, it might also be non-solvably combinable or permanently attached to the roll. Further, an insulating layer which is adapted to be seamlessly applied can also be a solid according to further alternative implementations.

According to embodiments described herein, improved insulating layers are provided. The insulating layers are provided in insulating areas outside a central area. Typically the central area on the roll has a metallic surface. According to different embodiments, the insulating layers can be applied as vapour or fluid. In alternative embodiments the insulating layers are applied in solid form. According to some embodiments, which can be combined with all other embodiments, the insulating layers can be applied to be seamless and/or the insulating layers can have a thickness such that a closed layer is provided. This may be for example, in a range of 0.1 to 10 times or 0.2 to 5 times the thickness of the flexible substrate. Typical values might be 15 µm or less, e.g., in a range from 0.2 µm to 10 µm.

According to other embodiments, which can be combined with any of the embodiments described herein, at least one insulating layer includes a polymer. This polymer may be a film-forming or layer-forming polymer. The polymer may be an anionic, nonionic, zwitterionic or amphoteric polymer. The polymer may be a crotonic acid or acrylic acid copolymer, or vinyl pyrrolidone/vinyl acetate/itaconic acid terpolymers, or a polymer such as a vinyl alkyl ether, possibly partially esterified, or any other polymer known to persons skilled in the art. Other film-forming agents may be applied as insulating layers such as film-forming agents of natural origin, e.g., chitosane or derivates thereof.

According to further typical modifications, the polymer is provided in a solvent. Solvents may include water-based parts, alcohols or hydrocarbons. Solvents may, e.g., include lower alcohols such as ethanol, n-propanol or isopropyl alcohol.

Specifically, in some embodiments, the polymer and a solvent are contained in a spray. The spray may also contain propellants. Propellants may include compressed gases, e.g. nitrogen or aerosols such as dimethyl ether, propane, butane or isobutene. In alternative embodiments, the spray is a pump spray. The pump spray may include a mechanical pumping mechanism.

However, it might also be possible that at least one insulting layer is provided in solid form, e.g., a shrinkable tubing or the like, as long as it can be applied seamless and sufficiently thin.

According to yet other embodiments, which can be combined with any of the embodiments described herein, at least one insulating layer is thinner than 10 µm, typically thinner than 1 µm, e.g., 0.5 µm.

Generally, according to embodiments described herein, which can be combined with any other embodiment, the roll can have a metallic surface. Further, according to other alternative or additional embodiments, the width of the roll may be at least 200 mm. For example, it can be 300 to 6000 mm, 600 to 800 mm, about 2000mm, 2100 to 2200 mm, or about 4650 mm.

According to an embodiment, a method of manufacturing a coating device for coating a flexible substrate is provided, the coating device having a roll with a rotation axis. The method includes defining a flexible substrate receiving area having border regions adapted to receive edges of a flexible substrate, applying two or more insulating layers as vapor or fluid on the roll in the border regions such that a first insulating layer is applied on a first area and a second insulating layer is applied on a second area on the surface of the roll, the first and second area being substantially circumferential, and wherein there is a central area between the first and second area.

According to typical implementations, applying the two or more insulating layers may be realized by spraying, by painting, by printing or by sputtering. In one implementation, a polymer is sprayed on the surface of the roll. Thereby, the polymer can, for example, be contained in spray which is sprayed on the surface of the roll. Other embodiments may provide a brush and a reservoir with material for painting the layers or in another manner that provides a typically seamless insulating layer in the metal surface of the roll. Likewise, a printing head, e.g. with some cartridge containing the material, may be provided for printing the insulating layers on the roll; or the layers may be applied by sputtering from a sputtering source or being deposited as vapor from an evaporation source. According to embodiments, which can be combined with other embodiments described herein, the insulating layers can be solvably combinable with the roll. As described above, this can for example be realized with spray, paint or lacquer. However, it can also be possible that a non solvably combinable layer is provided on the roll, e.g. forming a permanent layer that is not erased during a cleaning process.

In some embodiments, a spray or brush or printing head or sputtering source or evaporation source is moved circumferentially around the roll to produce substantially circumferential layers. In other embodiments, the roll may be rotated while these tools stay fixed or move axially if a more general form of a layer area than a mere circumferential stripe is desired. Generally, insulating layers may be applied on areas of various size and arbitrary shape. In particular, the layer areas need not be circumferentially closed areas although in typical embodiments they are circumferentially closed. In typical embodiments, insulating layers are applied seamlessly, e.g. in form of a polymer such as a polymer contained in spray.

In further typical embodiments a mask or templet is used that may be brought in contact with or close to the surface of the roll as shown in Figure 3. Figure 3 shows two different options that can be used independently or combined. The use of a mask 360 may facilitate the application of vapors or fluids by spraying, painting, printing or sputtering since it predefines the area on the surface of the roll on which the vapor or fluid is intended to be applied. In some embodiments, a mask may only predefine one dimension of the area on which an insulating layer is intended to be applied. For example, a mask 370 may only define the axial dimension of the layer area, which is the dimension in the direction parallel to the axis of the roll. In other embodiments, the roll may be rotated under the mask enabling, as above, the material source or the applying tool to stay at a fixed position or to move, together with the mask, in axial direction. The use of a mask may be combined with any of the above or other ways of applying the insulating layers yielding further embodiments. In typical embodiments, a spray including a polymer is applied using a mask as described above. In further embodiments, a mask may be held in a desired place by some holding device.

In another embodiment, a method of manufacturing a coating device for coating a flexible substrate is provided. The method includes applying one or more insulating layers adapted to be seamlessly applied on a roll having an axis, wherein at least one insulating layer is solvably combinable with the roll.

According to yet another embodiment, a method of manufacturing a coating device includes applying two or more insulating layers adapted to be seamlessly applied on a roll having an axis, wherein a first insulating layer is applied on a first area and a second insulating layer is applied on a second area on the surface of the roll, the first and second area being substantially circumferential, and wherein there is a central area between the first and second area. Therein, according to typical embodiments, the at least one insulating layer can be solvably combinable with the roll.

In typical embodiments, one or more insulating layers are sprayed on the surface of the roll. In other embodiments, one or more insulating layers are painted, printed or sputtered on the surface of the roll. Therein, the spray, paint, lacquer, printing material or sputtering material may be adapted to be seamlessly applied. Typically but not necessarily, these materials are seamlessly applied. In typical embodiments, these insulating layers are solvably combinable with the roll. In particular, a sprayed-on polymer may form an insulating layer according to the above specification. Naturally, there is no limitation to sprays or polymers, and other fluids or vapors may be used yielding further embodiments.

In yet further embodiments, solid materials are applied as insulating layers. In some embodiments the solid materials are adapted to be seamlessly applied and, typically but not necessarily, are seamlessly applied. Therein, solid materials may be applied on the roll solvably combinably with the roll. In some embodiments, the solid material is a shrinking tube. A shrinking tube may be seamless a priori. In other embodiments, some other solid material is applied that can become seamless a posteriori, i.e., after application. An example is a material whose ends can be fused. A solvable combination with the roll may refer to a mechanical detachment, wherein residues of any attaching, glue-like material on the roll may be wiped off easily.

According to other embodiments, a method of manufacturing a coating device for coating a flexible substrate is provided. The method includes applying two or more insulating layers that are thinner than 10 µm on a roll having an axis. In some embodiments, a first insulating layer is applied on a first area and a second insulating layer is applied on a second area on the surface of the roll. Therein the first and second area may be substantially circumferential. There can be a central area between the first and second area.

The application of insulating layers may be effected manually, semi-automated or automated or in any other way. A semi-automated or automated application may necessitate the use of robot assemblies or the like, of controllers such as computers, of controlling programs or other pieces of hardware or software.

According to further embodiments a method of operating a coating device for coating a flexible substrate is provided. The method includes applying at least one insulating layer according to any of the embodiments described above. The method further includes applying a voltage difference between the roll and the flexible substrate. In some embodiments, the voltage difference is from 1 to 400 V, typically from 100 to 200 V or, especially in Ultra Thin Film (UTF) applications, only a few volts, but is not limited to either range. According to further embodiments, the method includes guiding a flexible substrate within a flexible substrate receiving area. Typically, a substrate receiving area has two boundaries which are circumferential on the surface of the roll. Therein the first boundary lies within a first area on which an insulating layer is applied and the second boundary lies within a second area on which an insulating layer is applied.

According to another embodiment at least one boundary lies within an area of an insulating layer which is adapted to be seamlessly applied on the roll. In further embodiments such an insulating layer is solvably combinable with the roll. According to further embodiments, the method includes coating of the flexible substrate. In other embodiments, the method includes guiding the flexible substrate out of the flexible substrate receiving area. Thereby, the flexible substrate is detached from the roll.

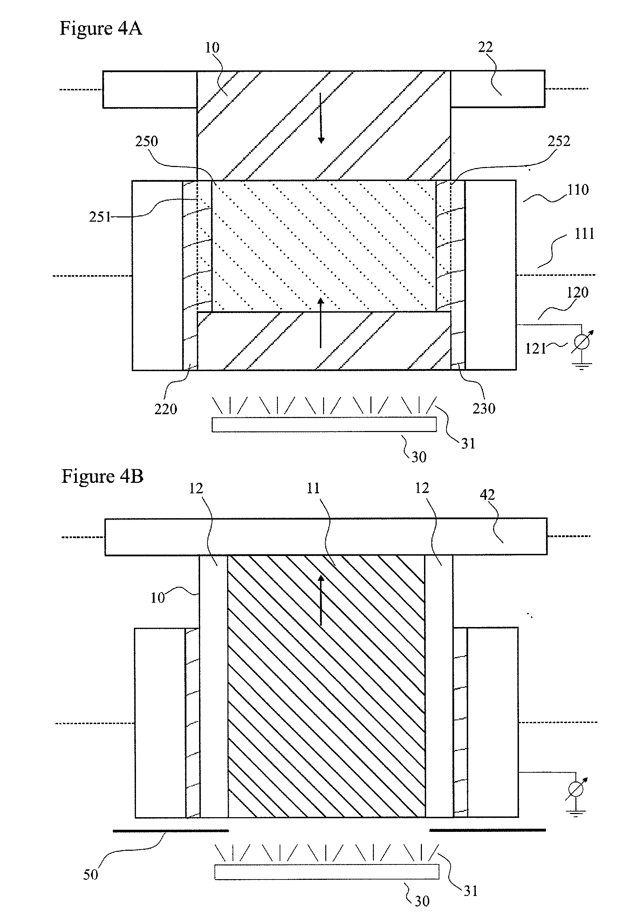

Figure 4A shows exemplary embodiments of the invention relating to a method of operating a coating device. In Fig. 4A, insulating layers 220 and 230 are applied. A flexible substrate 10, e.g., film or foil, is guided in the direction indicated by the arrows. Optionally, further rolls may be present, e.g., a first roll from which the flexible substrate is unwound (not shown) or a second roll on which the flexible substrate is wound. According to other embodiments, which can be combined with any of the embodiments described herein, one or more additional rolls 22 may be provided on one or each side of the processing roll 110. These additional rolls may be used for guiding the flexible substrate, controlling the tension of the flexible substrate, providing or removing charge from the flexible substrate, and combinations thereof. In typical embodiments, the flexible substrate is guided within a flexible substrate receiving area 250 of the roll in those places where it is in contact with the roll.

As indicated in Fig. 4A, the web 10 is guided over the roller 22, from which it is passed to roll 110. As shown in Fig. 4, the substrate 10 travels on the substrate receiving area 250 on roll 110. For easier understanding, the substrate is not shown to be guided over the entire roll 110.

The substrate receiving area has two boundaries 251 and 252, which are within the areas 220 and 230 of the first insulating layer and the second insulating layer, respectively. Further, a coating material source 30 is shown, which coats the substrate 10 on the roll 110. For easier reference, a shielding of the material 31, a masking of the material 31 or other means for creating unmetalized free margins is not shown in Fig. 4A. According to different embodiments, which can be combined with any of the embodiments described herein, it is possible to provide a coating of the substrate such that unmetalized free margins on the substrate are provided, to provide a coating such that the entire substrate is coated or to provide a coating such that there is an overmetalization, i.e., such that coating material is provided also beyond, i.e. outside, the boundaries 251 and 252. Overmetalization might have the benefit of producing additional coated area on the substrate, which increases the throughput.

In particular for embodiments providing substrates with an unmetalized edge, an insulating layer can be provided in order to improve the coating device and/or the coating of flexible substrates. Generally, another charging behavior of an uncoated edge of the substrate as compared to a metalized region of the substrate can occur. For example, a charging of the web can be increased in an unmetalized edge region. Accordingly, an insulating polymer can be used to improve the leaving of the flexible substrate 10 from the coating drum or roll 110.

A corresponding situation is shown in Fig. 4B. Therein, a metallization area 11 of the flexible substrate 10 is shown between unmetalized margin areas 12, the areas being generated with a mask 50. Further, a roll 42 is shown, which is provided, in substrate moving direction, after the roll 110. The substrate 10 is guided from the roll 110 to the roll 42. For easier understanding, the substrate is not shown to be guided over the roll 42.

In some embodiments, the flexible substrate is coated with material 31 from a coating material source 30. Coating can be carried out in any way known to a person skilled in the art, e.g. by applying metallic vapor on the flexible substrate. According to embodiments described herein, a coating of the flexible substrate might be provided within the edges of the flexible substrate, to a width substantially corresponding to the width of the flexible substrate or beyond the edges of the flexible substrate. In the latter case, the insulating layers typically extend to an axial width adapted to protect the metallic surface of the roll from being coated.

In further embodiments, the flexible substrate is guided out of the flexible substrate receiving area.

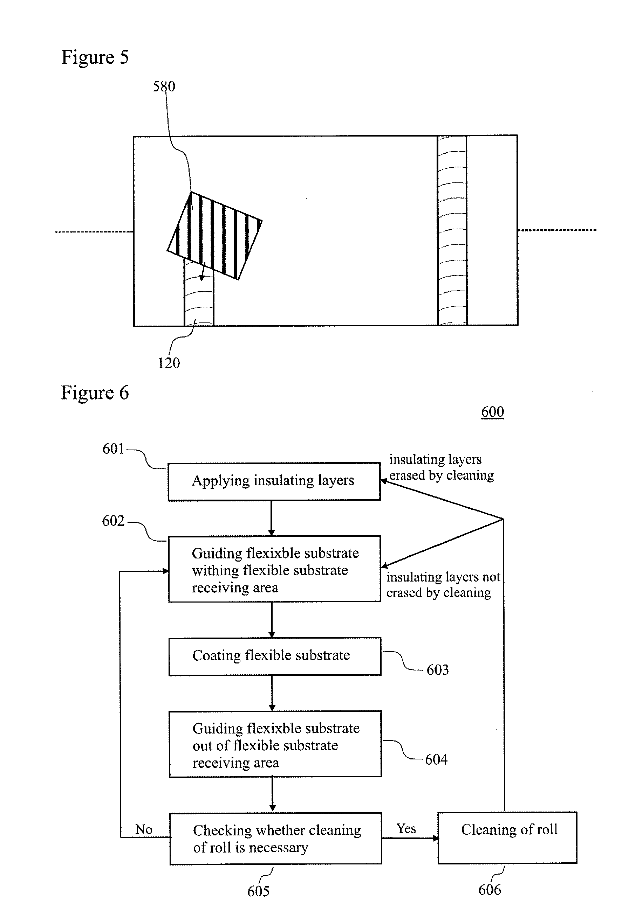

Fig. 5 illustrates embodiments of the invention relating to removing of insulating layers. Fig. 5 shows wiping means 580 removing insulating layer 220 by wiping. In some embodiments, removal of at least one insulating layer is executed manually. In alternative embodiments, removal of at least one insulating layer is executed in a semi-automated or automated way, possibly requiring further hardware or software.

Thus, according to some embodiments, a method of operating a coating device includes removing at least one insulating layer. In yet further embodiments, the method further includes re-applying at least one insulating layer according to method steps of other embodiments described above. Such removing could, e.g., be necessary in a cleaning process of the roll. This cleaning process may be necessary because of coating material having been applied beyond the edges of a flexible substrate. In embodiments wherein insulating layers have been applied to the roll in a solvably combinable way, removing these layers could be carried out by means of wiping, possibly using a solvent, mechanical detachment, possibly followed by wiping off of residues of an attaching substance, possibly using a solvent, or by any other means not requiring an undue effort. Insulating layers non solvably combined with the roll may, according to other embodiments, be removed by means requiring an undue effort such as the use of abrasive objects.

Figure 6 illustrates embodiments of the present invention in a flow-chart 600. Insulating layers are applied to a roll, symbolized by flow-chart box 601. In other embodiments, a flexible substrate is guided within a flexible substrate receiving area in step 602. Guiding can include transporting a flexible substrate, e.g. a film or foil, in a roll-to-roll process. A flexible substrate is coated in step 603. A flexible substrate is guided out of a flexible substrate receiving area in step 604. This guiding can include a detachment of the flexible substrate from a roll, e.g. a processing roll. In a roll-to-roll process, this guiding may also include finalizing the roll-to-roll process. As shown in Figure 6, a check is performed whether cleaning of the roll is necessary in step 605. If the check is negative, i.e., no cleaning of the roll is needed, operation of a coating device may continue with further steps including, e.g., the steps 602 to 605. In a roll-to-roll process, such a continuation can include the processing of a new roll of a flexible substrate. These and other steps may also be repeated without a check. If the check is positive, i.e., cleaning of the roll is needed, operation of a coating device may continue with further steps, e.g., with a cleaning step wherein the roll is cleaned. Cleaning of the roll may take place without a prior check. In some embodiments, insulating layers are erased by a cleaning step. Then, the operation of a coating device includes the further step 601 of re-applying insulating layers to the roll, possibly followed by other steps including the process steps 602 to 605. According to other embodiments, insulating layers are not erased in a cleaning step.

According to one embodiment of the invention, a coating device for coating a flexible substrate is provided. The coating device includes a roll having an axis and two or more insulating layers, wherein a first insulating layer is applied on a first area and a second insulating layer is applied on a second area on the surface of the roll, the first and second area being circumferential, and wherein at least one insulating layer is adapted to be applied as a vapor or as a fluid, and a central area between the first and second area, and a flexible substrate receiving area having two or more boundaries, wherein a first boundary lies within the first area and a second boundary lies within the second area. In a typical embodiment, at least one area out of the set of areas include the first and second area has a width between 5 and 15 mm.

According to a further embodiment, a mask for use in a coating device as described herein is provided. The mask includes at least one opening defining at least one dimension of the first and/or the second area.

According to another embodiment, a coating device for coating a flexible substrate is provided. The coating device includes a roll having an axis and two or more insulating layers adapted to be seamlessly applied on the roll. Therein, a first insulating layer is applied on a first area and a second insulating layer is applied on a second area on the surface of the roll, the first and second area being substantially circumferential. Further, the coating device includes a central area between the first and second area and a substrate receiving area having two or more boundaries, wherein a first boundary lies within the first area and a second boundary lies within the second area. In a further embodiment, at least one insulating layer is solvably combinable with the roll.

Additional or alternative implementations, which can be combined with other embodiments described herein, the coating device can be provided as follows. Embodiments are also directed to a coating device for coating a flexible substrate wherein at least one insulating layer of the two or more insulating layers can include a polymer. In some embodiments, the polymer can be a crotonic acid or acrylic acid copolymer or a vinyl alkyl ether or a vinyl ester. In some embodiments, at least one insulating layer can be thinner than 10 µm. In other embodiments, the width of the roll can be substantially from 300 to 6000 mm. According to a further embodiment, the surface of the roll can be metallic.

According to yet other embodiments, methods of manufacturing a coating device are provided. Thereby, according to one embodiment, a method of manufacturing a coating device includes applying two or more insulating layers as vapor or fluid on a roll having an axis, wherein a first insulating layer is applied on a first area and a second insulating layer is applied on a second area on the surface of the roll, the first and second area being substantially circumferential, and wherein there is a central area between the first and second area. In further embodiments, least one insulating layer is solvably combinable with the roll.

According to still another embodiment, a method of manufacturing a coating device includes applying two or more insulating layers adapted to be seamlessly applied on a roll having an axis, wherein a first insulating layer is applied on a first area and a second insulating layer is applied on a second area on the surface of the roll, the first and second area being substantially circumferential, and wherein there is a central area between the first and second area. In further embodiments, at least one insulating layer is solvably combinable with the roll.

Some embodiments are directed to methods of manufacturing a coating device wherein the coating device can include further additional or alternative details. These details may be: the width of at least one area out of a set of areas include the first and second area being between from 5 to 15 mm; a mask including at least one opening defining at least one dimension of the first and/or the second area; inclusion of a polymer in at least one insulating layer out of the two or more insulating layers; a polymer, included in at least one insulating layer out of the two or more insulating layers, being a crotonic acid or acrylic acid copolymer or a vinyl alkyl ether or a vinyl ester; the thickness of at least one insulating layer out of the set of two or more insulating layers being thinner than 10 µm; the width of the roll being substantially from 300 to 6000 nm; and/or the surface of the roll being metallic.

Other embodiments are directed to a method of operating a coating device. The method may include above methods of manufacturing a coating device. The method includes applying a voltage difference between the roll and the flexible substrate, guiding the flexible substrate within a flexible substrate receiving area having two or more boundaries, wherein a first boundary lies within the first area and a second boundary lies within the second area, coating the flexible substrate, and guiding the flexible substrate out of the flexible substrate receiving area. In yet further embodiments, the voltage difference is substantially from 1 to 400 V. In some embodiments, the method of operating a coating device further includes removing at least one insulating layer and re-applying at least one insulating layer.

While the foregoing is directed to embodiments of the invention, other and further embodiments of the invention may be devised without departing from the basic scope thereof, and the scope thereof is determined by the claims that follow.

## Claims

1. A coating device for coating a flexible substrate comprising:
a roll having an axis,
two or more insulating layers,
wherein a first insulating layer is applied on a first area and a second insulating layer is applied on a second area on the surface of the roll,
the first and second area being substantially circumferential,
and wherein at least one insulating layer is adapted to be applied as a vapor or as a fluid,
a central area between the first and second area,
a flexible substrate receiving area having two or more boundaries,
wherein a first boundary lies within the first area and a second boundary lies within the second area.

2. A coating device according to claim 1,
wherein at least one area out of a set of areas comprising the first and second area has a width between 5 and 15 mm.

3. A mask for use in a coating device according to any of the claims 1 to 2 comprising:
at least one opening defining at least one dimension of the first and/or the second area.

4. A coating device for coating a flexible substrate comprising:
a roll having an axis, two or more insulating layers adapted to be seamlessly applied on the roll,
wherein a first insulating layer is applied on a first area and a second insulating layer is applied on a second area on the surface of the roll,
the first and second area being substantially circumferential,
a central area between the first and second area,
a flexible substrate receiving area having two or more boundaries,
wherein a first boundary lies within the first area and a second boundary lies within the second area.

5. A coating device according to any of the claims 1 to 4,
wherein at least one insulating layer of the two or more insulating layers is solvably combinable with the roll.

6. A coating device according to any of the claims 1 to 5,
wherein at least one insulating layer of the two or more insulating layers comprises a polymer.

7. A coating device according to claim 6
wherein the polymer is a crotonic acid or acrylic acid copolymer or a vinyl alkyl ether or a vinyl ester.

8. A coating device according to any of the claims 1 to 7,
wherein at least one insulating layer is thinner than 10 µm.

9. A coating device according to any of the claims 1 to 8,
wherein the width of the roll is substantially from 300 to 6000 mm.

10. A coating device according to any of the claims 1 to 9,
wherein the surface of the roll is metallic.

11. A method of manufacturing a coating device for coating a flexible substrate comprising:
applying two or more insulating layers as vapor or fluid on a roll having an axis,
wherein a first insulating layer is applied on a first area and a second insulating layer is applied on a second area on the surface of the roll,
the first and second area being substantially circumferential,
and wherein there is a central area between the first and second area.

12. A method of manufacturing a coating device for coating a flexible substrate comprising:
applying two or more insulating layers adapted to be seamlessly applied on a roll having an axis,
wherein a first insulating layer is applied on a first area and a second insulating layer is applied on a second area on the surface of the roll,
the first and second area being substantially circumferential,
and wherein there is a central area between the first and second area.

13. A method of manufacturing a coating device according to any of the claims 11 to 12,
wherein at least one insulating layer is solvably combinable with the roll.

14. A method of manufacturing a coating device according to any of the claims 11 to 13,
wherein the coating device further comprises features as claimed in any of the claims 1 to 10.

15. A method of operating a coating device according to any of the claims 11 to 14 further comprising:
applying a voltage difference between the roll and the flexible substrate,
guiding the flexible substrate within a flexible substrate receiving area having two or more boundaries,
wherein a first boundary lies within the first area and a second boundary lies within the second area,
coating the flexible substrate,
guiding the flexible substrate out of the flexible substrate receiving area.

16. A method of operating a coating device according to claim 15,
wherein the voltage difference is substantially between 1 and 400 V.

17. A method of operating a coating device according to any of the claims 15 to 16 further comprising:
removing at least one insulating layer and re-applying at least one insulating layer.
